# EUROPEAN PATENT APPLICATION

(11) **EP 4 801 212 A1**
(43) Date of publication of application: **02.09.2026**
(21) Application number: 26158512.9
(22) Date of filing: 13.02.2026
(51) Int. Cl.: H05K 7/20

(54) **HEAT EXCHANGE LIQUID COOLING SYSTEM AND ITS CONTROL METHOD**

(30) Priority: 26.02.2025 US 202563763275 P; 26.09.2025 CN 202511385357
(71) Applicant: Lite-On Technology Corporation, Taipei City 11492 (TW)
(72) Inventor: CHIU, Yung-Chang, 11492 Taipei City (TW); FANG, Tzu-Cheng, 11492 Taipei City (TW); LIN, Chih-Chueh, 11492 Taipei City (TW)
(74) Representative: Bals & Vogel Patentanwälte PartGmbB

(57) **Abstract**

The disclosure provides a heat exchange liquid cooling system (1) and its control method. The heat exchange liquid cooling system (1) includes a liquid storage tank (10), a heat exchanger (40), a first liquid pipeline (20), a second liquid pipeline (30), a first circulation pump (50), a control valve (60), a first temperature sensor (80), and a control device (90). The heat exchanger (40) includes a first conduit (41) and a second conduit (45). The first conduit (41) connects a first liquid inlet (42) and a first liquid outlet (43), and the second conduit (45) connects a second liquid outlet (47). The first temperature sensor (80) is disposed within the second liquid outlet (47). The first temperature sensor (80) senses the temperature of the coolant inside the second liquid outlet (47) and generates a first temperature sensing signal (T1). The first temperature sensor (80) sends the first temperature sensing signal (T1) to the control device (90). The control device (90) controls the valve opening of the control valve (60) according to the first temperature sensing signal (T1).

## Description

### CROSS-REFERENCE TO RELATED APPLICATION

This application claims the benefits of priorities to the U.S. Provisional Patent Application Ser. No. 63/763,275 filed on Feb. 26, 2025, and Patent Application No. 2025113853570 filed on Sep. 26, 2025 in the People's Republic of China, which applications are incorporated herein by reference in their entireties.

### BACKGROUND OF THE INVENTION

### Technical Field

The disclosure relates to a cooling system and method, and in particular, to a heat exchange liquid cooling system used for information processing equipment and its control method.

### Prior Art

With the rapid advancement of technology, the demand for high-speed computing is increasing. General information processing equipment, such as servers, generates a large amount of heat during operation. Overheating can lead to slower operation speeds or system crashes. Therefore, there is a certain level of demand for high-efficiency heat dissipation. Conventional servers typically use air-cooling for heat dissipation. However, when cabinet temperatures rise rapidly, the existing air-cooling dissipation no longer meets the requirements. A liquid cooling system is a system that uses a liquid medium for heat exchange. Since the thermal conductivity of a liquid medium is much higher than that of the conventional air medium, this technology is regarded as one of the mainstream technologies for heat dissipation in future high-power systems. However, when the heat load, ambient temperature, or heat dissipation system conditions change suddenly, the slow control response speed of the liquid medium can prevent the system from quickly reaching the set thermal equilibrium point, which may cause system overheating. This, in turn, can affect the lifespan of components, and in severe cases, trigger over-temperature protection, leading to the serious loss of a system shutdown.

The content disclosed in the "Background Art" section is only used to facilitate understanding of the disclosure and may therefore include some conventional techniques not known to those with ordinary skill in the art. The content disclosed in the "Background Art" section does not imply that the content or one or more embodiments of the disclosure's problem to be solved were known or recognized by those with ordinary skill in the art before the filing of this application.

### SUMMARY OF THE INVENTION

The disclosure provides a heat exchange liquid cooling system and its control method that can timely measure and enhance the system's response speed to prevent system overheating.

Other objectives and advantages of the disclosure can be further understood from the technical features disclosed in the disclosure.

To achieve one or part or all of the above or other objectives, the disclosure provides a heat exchange liquid cooling system connected to an external cooling device. The heat exchange liquid cooling system includes a liquid storage tank, a heat exchanger, a first liquid pipeline, a second liquid pipeline, a first circulation pump, a control valve, a first temperature sensor, and a control device. The liquid storage tank is used to store coolant. The heat exchanger comprises a first conduit and a second conduit. The first conduit is connected to a first liquid inlet and a first liquid outlet. The second conduit is connected to a second liquid inlet and a second liquid outlet, and the second liquid outlet is connected to the liquid storage tank. One end of the first liquid pipeline is connected to the external cooling device and supplies coolant to the external cooling device. One end of the second liquid pipeline receives coolant returned from the external cooling device, and the other end of the second liquid pipeline is connected to the second liquid inlet. The first circulation pump is connected to the liquid storage tank and is configured to drive the liquid in the liquid storage tank to flow toward the first liquid pipeline. The control valve is connected to the first liquid outlet. The first temperature sensor is disposed within the second liquid outlet, sensing the temperature of the coolant inside the second liquid outlet and generating a first temperature sensing signal. The first temperature sensor sends the first temperature sensing signal to the control device, and the control device controls the valve opening of the control valve according to the first temperature sensing signal.

In some embodiments, the control device includes a first PID (Proportional-Integral-Derivative) control module, which calculates the valve opening of the control valve according to the first temperature sensing signal and a sensor target temperature.

In some embodiments, the heat exchange liquid cooling system further includes a second temperature sensor, disposed within the first liquid pipeline, sensing the temperature of the coolant inside the first liquid pipeline and generating a second temperature sensing signal.

In some embodiments, the control device further includes a second PID control module, wherein the second temperature sensor sends the second temperature sensing signal to the control device, and the second PID control module calculates the sensor target temperature according to the second temperature sensing signal and a water supply target temperature.

In some embodiments, the heat exchange liquid cooling system further includes a first check valve connected to the first circulation pump and the first liquid pipeline to prevent coolant backflow.

In some embodiments, the heat exchange liquid cooling system further includes a return water temperature sensor disposed in the second liquid pipeline, sensing the temperature of the coolant at the second liquid pipeline.

In some embodiments, the heat exchange liquid cooling system further includes a liquid cooling tower connected to the first liquid inlet and the first liquid outlet.

In some embodiments, the heat exchanger is a plate heat exchanger.

In some embodiments, the heat exchange liquid cooling system further includes a second circulation pump, set up in parallel with the first circulation pump, and the second circulation pump is connected to the liquid storage tank and configured to drive the liquid in the liquid storage tank to flow toward the first liquid pipeline.

In some embodiments, the heat exchange liquid cooling system further includes a first check valve and a second check valve, the first check valve is connected to the first circulation pump and the first liquid pipeline to prevent coolant backflow, and the second check valve is connected to the second circulation pump and the first liquid pipeline to prevent coolant backflow.

In some embodiments, the control valve is a proportional control valve.

In some embodiments, the first conduit, the first liquid inlet, the first liquid outlet, and the control valve form a part of the primary side circulation.

In some embodiments, the second conduit, the second liquid inlet, the second liquid outlet, and the first temperature sensor form a part of the secondary side circulation.

To solve the above technical problem, the disclosure further provides a control method for a heat exchange liquid cooling system. The heat exchange liquid cooling system is connected to an external cooling device, and includes a liquid storage tank, a heat exchanger, a first liquid pipeline, a second liquid pipeline, a first circulation pump, a control valve and a control device. The heat exchanger includes a first conduit and a second conduit. The first conduit connects a first liquid inlet and a first liquid outlet. The second conduit connects a second liquid inlet and a second liquid outlet, and the second liquid outlet is connected to the liquid storage tank. One end of the first liquid pipeline is connected to the external cooling device and supplies coolant to the external cooling device. One end of the second liquid pipeline receives coolant returned from the external cooling device, and the other end of the second liquid pipeline is connected to the second liquid inlet. The first circulation pump is connected to the liquid storage tank and is configured to drive the liquid in the liquid storage tank to flow toward the first liquid pipeline. The control valve is connected to the first liquid outlet. The control method includes the following steps: sensing the temperature of the coolant inside the second liquid outlet through a first temperature sensor and generating a first temperature sensing signal; inputting the first temperature sensing signal and a sensor target temperature into a first PID (Proportional-Integral-Derivative) control module, and the first PID control module calculating the valve opening of the control valve according to the first temperature sensing signal and the sensor target temperature to control the control valve.

In some embodiments, the control method for a heat exchange liquid cooling system further includes: sensing the temperature of the coolant inside the first liquid pipeline through a second temperature sensor and generating a second temperature sensing signal.

In some embodiments, the control method for a heat exchange liquid cooling system further includes: inputting the second temperature sensing signal and a water supply target temperature into a second PID control module; and the second PID control module calculates the sensor target temperature according to the second temperature sensing signal and the water supply target temperature.

The disclosure provides a heat exchange liquid cooling system and its control method. By having a first conduit and a second conduit in the heat exchanger, where the first conduit forms the primary side circulation and the second conduit forms the secondary side circulation, and by setting a first temperature sensor at the second liquid outlet side of the second conduit to sense the coolant temperature, the first temperature sensor generates a first temperature sensing signal. The control device then controls the valve opening of the control valve according to the first temperature sensing signal. This allows for timely sensing and enhanced system response speed to prevent system overheating. Additionally, since the sensor target temperature can be calculated according to the second temperature sensing signal generated by the second temperature sensor and the water supply target temperature, the sensor target temperature can be adjusted at any time, further improving the response speed and avoiding the system overheating.

### BRIEF DESCRIPTION OF THE DRAWINGS

Fig. 1 is a schematic structural diagram of the liquid cooling system of the disclosure.
Fig. 2 is a schematic diagram of an embodiment of the liquid cooling control device of the disclosure.
Fig. 3 is a flowchart of an embodiment of the liquid cooling control method of the disclosure.

### DETAILED DESCRIPTION OF THE INVENTION

The foregoing and other technical content, features, and effects of the disclosure will be clearly presented in the following detailed description of a preferred embodiment with reference to the accompanying drawings. Directional terms mentioned in the following embodiments, such as upper, lower, left, right, front, or back, are for reference to the accompanying drawings only. Therefore, the directional terms used are for explanation and not for limiting the disclosure.

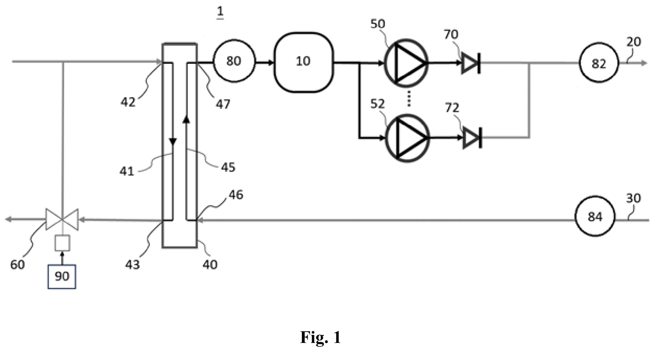

Fig. 1 is a schematic structural diagram of the liquid cooling system of the disclosure. As shown, the disclosure is a heat exchange liquid cooling system 1 connected to an external cooling device (not shown). The heat exchange liquid cooling system 1 includes a liquid storage tank 10, a heat exchanger 40, a first liquid pipeline 20, a second liquid pipeline 30, a first circulation pump 50, a control valve 60, a first temperature sensor 80, and a control device 90. The liquid storage tank 10 is used to store coolant. The heat exchanger 40 includes a first conduit 41 and a second conduit 45. The first conduit 41 is connected to a first liquid inlet 42 and a first liquid outlet 43. The second conduit 45 is connected to a second liquid inlet 46 and a second liquid outlet 47, and the second liquid outlet 47 is connected to the liquid storage tank 10. One end of the first liquid pipeline 20 is connected to the external cooling device (not shown) and supplies coolant to the external cooling device. It should be noted that the external cooling device can be, for example, a water-cooling plate or water-cooling block installed on an external server to carry away the heat emitted by the internal components of the external server for cooling and temperature reduction. One end of the second liquid pipeline 30 receives coolant returned from the external cooling device, and the other end of the second liquid pipeline 30 is connected to the second liquid inlet 46. The first circulation pump 50 is connected to the liquid storage tank 10 and is configured to drive the liquid in the liquid storage tank 10 to flow toward the first liquid pipeline 20. The control valve 60 is connected to the first liquid outlet 43. The first temperature sensor 80 is disposed within the second liquid outlet 47, sensing the temperature of the coolant inside the second liquid outlet 47 and generating a first temperature sensing signal T1. The first temperature sensor 80 sends the first temperature sensing signal T1 to the control device 90. For example, the first temperature sensor 80 may send the first temperature signal T1 to the control device 90 through a wireless connection or through a wireless communication link. The control device 90 controls the valve opening of the control valve 60 according to the first temperature sensing signal T1 to control the fluid flow, thereby enhancing the response speed of the heat exchange liquid cooling system 1. In some embodiments, the control device 90 includes an actuator, and the actuator of the control device 90 controls the valve opening of the control valve 60. It should be noted that the heat exchanger 40 may be, for example, a plate heat exchanger, but is not limited thereto. The control valve 60 may be, for example, a proportional control valve, but is not limited thereto.

In some embodiments, the heat exchange liquid cooling system 1 may further include a liquid cooling tower (not shown in the Figures). The liquid cooling tower may be connected to the first liquid inlet 42 and the first liquid outlet 43 within the heat exchanger 40. Liquid can flow through the first conduit 41 for heat exchange. The control valve 60 is connected to the first liquid outlet 43. The control device 90 controls the valve opening of the control valve 60 according to the first temperature sensing signal T1 generated by the first temperature sensor 80, thereby adjusting the coolant flow as needed to form the primary side circulation. Thus, the coolant may flow from the liquid cooling tower through the first liquid inlet 42, the first conduit 41, the first liquid outlet 43, the control valve 60 and back to the liquid cooling tower, thus forming a primary side path for coolant flow. The first conduit 41, the first liquid inlet 42, the first liquid outlet 43, and the control valve 60 may form a part of the primary side circulation.

As shown in Fig.1, the second liquid inlet 46 within the heat exchanger 40 receives the liquid returned from the second liquid pipeline 30. The liquid enters the heat exchanger 40 and flows through the second conduit 45 for heat exchange, then flows out from the second liquid outlet 47 into the liquid storage tank 10. The first temperature sensor 80 is disposed on one side of the second liquid outlet 47 to sense the coolant temperature. The first temperature sensor 80 senses the temperature of the coolant inside the second liquid outlet 47 and generates the first temperature sensing signal T1. The liquid storage tank 10 is connected to the first circulation pump 50. The first circulation pump 50 drives the liquid in the liquid storage tank 10 to flow toward the first liquid pipeline 20. The first liquid pipeline 20 is connected to the external cooling device (not shown) and supplies coolant to the external cooling device, forming the secondary side circulation. Thus, the coolant may flow through the second liquid inlet 46, the second conduit 45, the second liquid outlet 47, the first temperature sensor 80, the liquid storage tank 10, the first circulation pump 50, the first liquid pipeline 20 and back to the external cooling device, thus forming a secondary side path for coolant flow. The second conduit 45, the second liquid inlet 46, the second liquid outlet 47, and the first temperature sensor 80 form a part of the secondary side circulation.

In some embodiments, the heat exchange liquid cooling system 1 may further include a first check valve 70. The first check valve 70 is connected to the first circulation pump 50 and the first liquid pipeline 20 to prevent coolant backflow. The heat exchange liquid cooling system 1 may also include a second circulation pump 52 set up in parallel with the first circulation pump 50, if needed. The second circulation pump 52 is connected to the liquid storage tank 10 and is configured to drive the liquid in the liquid storage tank 10 to flow toward the first liquid pipeline 20. Similarly, a second check valve 72 is connected to the second circulation pump 52 and the first liquid pipeline 20 to prevent coolant backflow. It should be noted that the embodiments of the disclosure are not limited to this, and multiple parallel circulation pumps and multiple corresponding check valves can be installed to enhance the overall circulation efficiency of the system.

In some embodiments, a second temperature sensor 82 is disposed in the first liquid pipeline 20 and senses the temperature of the coolant inside the first liquid pipeline 20; a return water temperature sensor 84 is disposed in the second liquid pipeline 30 and senses the temperature of the coolant at the second liquid pipeline 30. The heat exchanger 40 can be, for example, a plate heat exchanger, but is not limited thereto. It should be noted that the return water temperature sensor 84 may sense the temperature of the liquid returning to the system at the second liquid pipeline 30. The returning liquid at the second liquid pipeline 30 is likely the liquid provided by the equipment (e.g., a heat-generating server) for liquid cooling. The temperature sensed by the return water temperature sensor 84 is generally higher than the temperature sensed by the second temperature sensor 82.

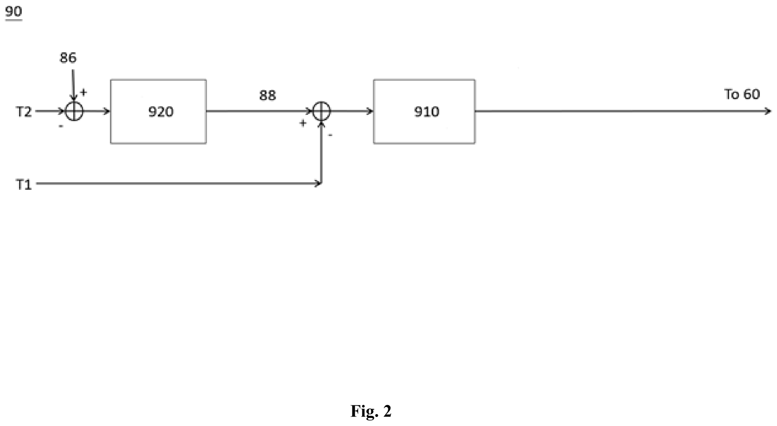

Fig. 2 is a schematic diagram of an embodiment of the liquid cooling control device of the disclosure. Please refer to Fig. 1 simultaneously. As shown in Fig. 2, the control device 90 includes a first PID (Proportional-Integral-Derivative) control module 9, which calculates the valve opening of the control valve 60 according to the first temperature sensing signal T1 and the sensor target temperature 88. The heat exchange liquid cooling system 1 further includes a second temperature sensor 82. The second temperature sensor 82 is disposed within the first liquid pipeline 20, senses the temperature of the coolant inside the first liquid pipeline 20 and generates a second temperature sensing signal T2. The control device 90 further includes a second PID control module 920. The second PID control module 920 may calculate the sensor target temperature 88 according to the second temperature sensing signal T2 and the water supply target temperature 86. The calculated sensor target temperature 88 is input into the first PID control module 910. The first PID control module 910 calculates the valve opening of the control valve 60 according to the first temperature sensing signal T1 and the sensor target temperature 88. The water supply target temperature 86 is a target temperature for the coolant which flows through the first liquid pipeline 20 and is provided to the external cooling device. For example, the control device 90 or the second PID control module 920 may set the temperature value of the water supply target temperature 86. In some embodiments, the water supply target temperature 86 may also be set by the user or operator of the heat exchange liquid cooling system 1. The first PID control module 910 may calculate the valve opening of the control valve 60 according to the first temperature sensing signal T1 and the sensor target temperature 88, thereby controlling the flow path size or the liquid flow through the control valve 60. By controlling the control valve 60, the system's heat dissipation amount is regulated. The control valve 60 determines the liquid flow through the primary side of the heat exchanger. The use of the first temperature sensor 80 allows for faster adjustment of the control valve 60 to regulate the system's heat dissipation amount. Since this control method calculates and adjusts the sensor target temperature 88, it prevents over-adjustment of the temperature (sensed by the second temperature sensor 82) at the outlet of the first liquid pipeline 20 in the heat exchange liquid cooling system 1.

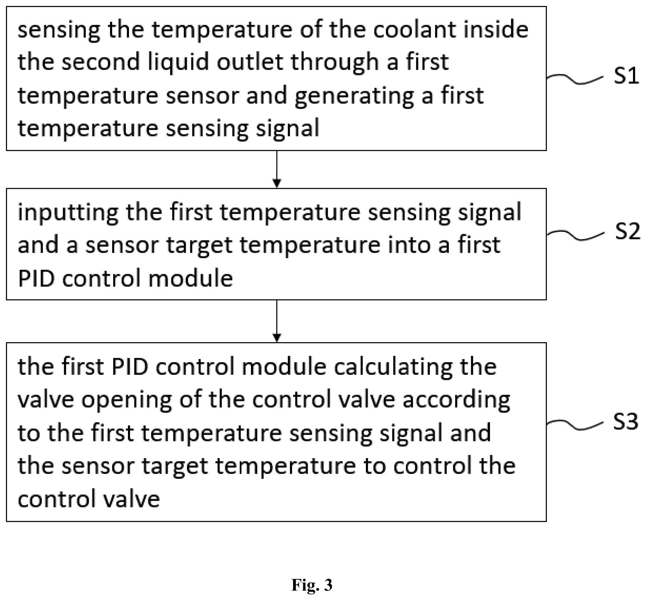

Fig. 3 is a flowchart of an embodiment of the liquid cooling control method of the disclosure. The control method for a heat exchange liquid cooling system may be used for the heat exchange liquid cooling system. The heat exchange liquid cooling system is connected to an external cooling device and includes a liquid storage tank, a heat exchanger, a first liquid pipeline, a second liquid pipeline, a first circulation pump, a control valve and a control device. The heat exchanger includes a first conduit and a second conduit. The first conduit is connected to a first liquid inlet and a first liquid outlet. The second conduit is connected to a second liquid inlet and a second liquid outlet, and the second liquid outlet is connected to the liquid storage tank. One end of the first liquid pipeline is connected to the external cooling device and supplies coolant to the external cooling device. One end of the second liquid pipeline receives coolant returned from the external cooling device, and the other end of the second liquid pipeline is connected to the second liquid inlet. The first circulation pump is connected to the liquid storage tank and is configured to drive the liquid in the liquid storage tank to flow toward the first liquid pipeline. The control valve is connected to the first liquid outlet. The control method for the heat exchange liquid cooling system includes the following steps: sensing the temperature of the coolant inside the second liquid outlet through a first temperature sensor and generating a first temperature sensing signal (Step S1); inputting the first temperature sensing signal and a sensor target temperature into a first PID (Proportional-Integral-Derivative) control module (Step S2); and the first PID control module calculating the valve opening of the control valve according to the first temperature sensing signal and the sensor target temperature to control the control valve (Step S3).

Please refer to Figs. 1 to 3 simultaneously. In one embodiment, the control method for the heat exchange liquid cooling system further includes: sensing the temperature of the coolant inside the first liquid pipeline 20 through a second temperature sensor 82 and generating a second temperature sensing signal T2. In some embodiments, the control method for the heat exchange liquid cooling system further includes: inputting the second temperature sensing signal T2 and a water supply target temperature 86 into a second PID control module 920; and the second PID control module 920 calculating the sensor target temperature 88 according to the second temperature sensing signal T2 and the water supply target temperature 86. The detailed description has been provided in the preceding paragraphs and will not be repeated here.

Please refer to Figs. 1 to 3 simultaneously. The heat exchange liquid cooling control method of the disclosure may be used for the heat exchange liquid cooling system 1. The heat exchange liquid cooling system 1 may be connected to an external cooling device (not shown) and includes a liquid storage tank 10, a heat exchanger 40, a first liquid pipeline 20, a second liquid pipeline 30, a first circulation pump 50, a control valve 60, and a control device 90. The heat exchanger 40 includes a first conduit 41 and a second conduit 45. The first conduit 41 is connected to a first liquid inlet 42 and a first liquid outlet 43. The second conduit 45 is connected to a second liquid inlet 46 and a second liquid outlet 47, and the second liquid outlet 47 is connected to the liquid storage tank 10. One end of the first liquid pipeline 20 is connected to the external cooling device and supplies coolant to the external cooling device. One end of the second liquid pipeline 30 receives coolant returned from the external cooling device, and the other end of the second liquid pipeline 30 is connected to the second liquid inlet 46. The first circulation pump 50 is connected to the liquid storage tank 10 and is configured to drive the liquid in the liquid storage tank 10 to flow toward the first liquid pipeline 20. The control valve 60 is connected to the first liquid outlet 43. The control method applied by the heat exchange liquid cooling system 1 involves: the first temperature sensor 80 sensing the coolant temperature inside the second liquid outlet 47 and generating the first temperature sensing signal T1; then inputting the first temperature sensing signal T1 and the sensor target temperature 88 into the first PID control module 910; and the first PID control module 910 calculating the valve opening of the control valve 60 based on the first temperature sensing signal T1 and the sensor target temperature 88 to control the control valve 60. By adjusting the flow path size or the liquid flow through the control valve 60, the overall heat exchange efficiency of the system is improved. The detailed description has been provided in the preceding paragraphs and will not be repeated here.

It should be noted that the preferred location for the installation of the first temperature sensor 80 is on the side of the second liquid outlet 47 of the heat exchanger 40, serving to timely measure the liquid temperature of the system's secondary side. If the temperature is too high, the control valve 60 located on the primary side of the system can be driven to timely adjust the liquid flow, providing more immediate heat dissipation for the heat exchanger 40.

In summary, the disclosure provides a heat exchange liquid cooling system and its control method. By having a first conduit and a second conduit in the heat exchanger, where the first conduit forms the primary side circulation and the second conduit forms the secondary side circulation, and by setting a first temperature sensor at the second liquid outlet side of the second conduit to timely measure the coolant temperature, when the coolant overheats, the first temperature sensor can immediately drive the control valve to adjust the liquid flow rate. This enables timely sensing and enhanced system response speed to prevent system overheating. Furthermore, since the sensor target temperature can be calculated according to the second temperature sensing signal generated by the second temperature sensor and the water supply target temperature, the sensor target temperature can be adjusted at any time, further improving the response speed and achieving the advantages of avoiding system overheating and avoiding over-adjustment of the temperature of the coolant inside the first liquid pipeline (sensed by the second temperature sensor) of the heat exchange liquid cooling system.

However, the above are only preferred embodiments of the disclosure, and the scope of implementation of the disclosure should not be limited by these. Any simple equivalent variations and modifications made according to the scope of the patent claims and the content of the description of the invention still fall within the scope covered by the patent of the disclosure. In addition, no single embodiment or claim of the disclosure is required to achieve all the objectives or advantages or features disclosed by the disclosure. Furthermore, the abstract and titles are only for assisting in patent document searching and are not intended to limit the scope of the rights of the disclosure. Moreover, the terms "first," "second," and the like mentioned in this specification or the patent claims are only used to name components or distinguish different embodiments or ranges, and are not intended to limit the upper or lower limit on the number of components.

## Claims

1. A heat exchange liquid cooling system (1), connected to an external cooling device, the heat exchange liquid cooling system (1) comprising:
a liquid storage tank (10), used for storing coolant;
a heat exchanger (40), including:
a first conduit (41), connected to a first liquid inlet (42) and a first liquid outlet (43); and
a second conduit (45), connected to a second liquid inlet (46) and a second liquid outlet (47), wherein the second liquid outlet (47) is connected to the liquid storage tank (10);
a first liquid pipeline (20), one end of the first liquid pipeline (20) connected to the external cooling device and supplying coolant to the external cooling device;
a second liquid pipeline (30), one end of the second liquid pipeline (30) receiving coolant returned from the external cooling device, and the other end of the second liquid pipeline connected to the second liquid inlet (46);
a first circulation pump (50), connected to the liquid storage tank (10) and configured to drive the liquid in the liquid storage tank (10) to flow toward the first liquid pipeline (20);
a control valve (60), connected to the first liquid outlet (43);
a first temperature sensor (80), disposed within the second liquid outlet (47), sensing the temperature of the coolant inside the second liquid outlet (47) and generating a first temperature sensing signal (T1); and
a control device (90);
wherein the first temperature sensor (80) sends the first temperature sensing signal (T1) to the control device (90), and the control device (90) controls the valve opening of the control valve (60) according to the first temperature sensing signal (T1).

2. The heat exchange liquid cooling system (1) as claimed in claim 1, wherein the control device (90) comprises a first PID (Proportional-Integral-Derivative) control module (910), the first PID control module (910) calculates the valve opening of the control valve (60) according to the first temperature sensing signal (T1) and a sensor target temperature (88).

3. The heat exchange liquid cooling as claimed in claim 2, further comprising a second temperature sensor (82), disposed within the first liquid pipeline (20), sensing the temperature of the coolant inside the first liquid pipeline (20) and generating a second temperature sensing signal (T2).

4. The heat exchange liquid cooling system (1) as claimed in claim 3, wherein the control device (90) further comprises a second PID control module (920);
wherein the second temperature sensor (82) sends the second temperature sensing signal (T2) to the control device (90), and the second PID control module (920) calculates the sensor target temperature (88) according to the second temperature sensing signal (T2) and a water supply target temperature (86).

5. The heat exchange liquid cooling system (1) as claimed in claim 1, further comprising a first check valve (70) connected to the first circulation pump (50) and the first liquid pipeline (20) to prevent coolant backflow.

6. The heat exchange liquid cooling system (1) as claimed in claim 1, further comprising a return water temperature sensor (84) disposed in the second liquid pipeline (30), sensing the temperature of the coolant at the second liquid pipeline (30).

7. The heat exchange liquid cooling system (1) as claimed in claim 1, further comprising a liquid cooling tower connected to the first liquid inlet (42) and the first liquid outlet (43).

8. The heat exchange liquid cooling system (1) as claimed in claim 1, wherein the heat exchanger (40) is a plate heat exchanger (40).

9. The heat exchange liquid cooling system (1) as claimed in claim 1, further comprising a second circulation pump (52), the second circulation pump (52) set up in parallel with the first circulation pump (50), and the second circulation pump (52) connected to the liquid storage tank (10) and configured to drive the liquid in the liquid storage tank (10) to flow toward the first liquid pipeline (20).

10. The heat exchange liquid cooling system (1) as claimed in claim 9, further comprising a first check valve (70) connected to the first circulation pump (50) and the first liquid pipeline (20) to prevent coolant backflow, and a second check valve (72) connected to the second circulation pump (52) and the first liquid pipeline (20) to prevent coolant backflow.

11. The heat exchange liquid cooling system (1) as claimed in claim 1, wherein the control valve (60) is a proportional control valve.

12. The heat exchange liquid cooling system (1) as claimed in claim 1, wherein the first conduit (41), the first liquid inlet (42), the first liquid outlet (43), and the control valve (60) form a part of the primary side circulation.

13. A control method for a heat exchange liquid cooling system (1), the heat exchange liquid cooling system (1) connected to an external cooling device, and the heat exchange liquid cooling system (1) comprising a liquid storage tank (10), a heat exchanger (40), a first liquid pipeline (20), a second liquid pipeline (30), a first circulation pump (50), a control valve (60) and a control device (90), the heat exchanger (40) including a first conduit (41) and a second conduit (45), the first conduit (41) connected to a first liquid inlet (42) and a first liquid outlet (43), the second conduit (45) connected to a second liquid inlet (46) and a second liquid outlet (47), the second liquid outlet (47) connected to the liquid storage tank (10), one end of the first liquid pipeline (20) connected to the external cooling device and supplying coolant to the external cooling device, one end of the second liquid pipeline (30) receiving coolant returned from the external cooling device, the other end of the second liquid pipeline (30) connected to the second liquid inlet (46), the first circulation pump (50) connected to the liquid storage tank (10) and configured to drive the liquid in the liquid storage tank (10) to flow toward the first liquid pipeline (20), the control valve (60) connected to the first liquid outlet (43), and the control method comprising the following steps:
sensing the temperature of the coolant inside the second liquid outlet (47) through a first temperature sensor (80) and generating a first temperature sensing signal (T1);
inputting the first temperature sensing signal (T1) and a sensor target temperature (88) into a first PID (Proportional-Integral-Derivative) control module (910); and
the first PID control module (910) calculating the valve opening of the control valve (60) according to the first temperature sensing signal (T1) and the sensor target temperature (88) to control the control valve (60).

14. The control method for a heat exchange liquid cooling system (1) as claimed in claim 13, further comprising:
sensing the temperature of the coolant inside the first liquid pipeline (20) through a second temperature sensor (82) and generating a second temperature sensing signal (T2).

15. The control method for a heat exchange liquid cooling system (1) as claimed in claim 14, further comprising:
inputting the second temperature sensing signal (T2) and a water supply target temperature (86) into a second PID control module (920); and
the second PID control module (920) calculating the sensor target temperature (88) according to the second temperature sensing signal (T2) and the water supply target temperature (86).
